Europäisches Patentamt

European Patent Office

Office européen des brevets

(11) Publication number : **0 654 908 A1**

(12) **EUROPEAN PATENT APPLICATION**

(21) Application number : **94420316.5**

(22) Date of filing : **15.11.94**

(51) Int. Cl.⁶ : **H03M 1/16**

(30) Priority : **22.11.93 US 156330**

(43) Date of publication of application :
**24.05.95 Bulletin 95/21**

(84) Designated Contracting States :
**DE FR GB**

(71) Applicant : **EASTMAN KODAK COMPANY**
**343 State Street**
**Rochester, New York 14650-2201 (US)**

(72) Inventor : **Boisvert, David Michael c/o Eastman**
**Kodak Company**
**Patent Legal Staff**
**343 State Street**
**Rochester, New York 14650-2201 (US)**

(74) Representative : **Buff, Michel et al**
**Kodak-Pathé**
**Département des Brevets et Licences CRT**
**Centre de Recherches et de Technologie**
**Zone Industrielle**
**F-71102 Chalon sur Saône Cédex (FR)**

(54) **Piecewise-linear gamma corrected analog to digital conversion system.**

(57)   An analog to digital conversion system which receives an input analog signal from, for example, an image sensor and converts it to a piecewise-linear gamma corrected digital signal. The system includes two conversion stages and interconnecting circuitry arranged to produce the corrected digital signal.

FIG. I

## Field of the Invention

The present invention relates to analog to digital conversion systems and, more particularly, to those which are suitable for converting an analog signal from an image sensor into a digital signal.

## BACKGROUND OF THE INVENTION

Digital electronic imaging systems which use charge coupled devices (CCDs) for image capture have common signal processing needs. These include correlated double sampling (CDS), voltage gain, dc level stabilization, and analog inversion. In earlier systems, these functions were realized using discrete electronic elements. Now, the need for more compact and cost-effective systems is driving designs towards the use of application-specific integrated circuits (ASICs) which integrate all of these functions into a single integrated circuit.

Two additional functions which are often used to process CCD output signals in digital imaging systems are gamma correction and analog-to-digital (A/D) conversion. In general, gamma correction refers to an input-output transfer function where

$$Vout = Vin^\gamma.$$

In many imaging systems, gamma=0.454 which causes low CCD signal levels to receive greater voltage gain than high CCD signal levels.

A/D conversion is a function which encodes continuously varying analog signals into discrete digital codes. A common A/D architecture is called a flash architecture. Here the analog voltage is presented to a bank of circuits (comparators) which compare this analog voltage to preset reference voltages. The comparators indicate whether the input voltage is above or below each reference voltage. The outputs of these comparators are then converted to a binary code which represents the analog input voltage.

The precision to which an analog voltage is encoded is often expressed in terms of the number of digital bits N, in the binary code. For example, the binary code 00010010 is said to be 8 bits wide (has 8 places each taking the value 0 or 1) and in this case represents the decimal value 18. Thus, an 8 bit digital code can represent up to 256 decimal values and can encode an analog voltage to an accuracy of 1 part in 256.

In the past, two stage type analog to digital conversion systems have been used with the first stage providing the most significant bits and the second stage the least significant bits. Such a system is shown in U.S. Patent 4,939,518. This system has problems in imaging applications in that the conversion is completely linear and does not provide enough quantization in the low level input signals and provides excess quantization in the high level input signals.

## SUMMARY OF THE INVENTION

It is an object of this invention to provide a multistage analog to digital conversion system with a piecewise-linear gamma correction transfer function.

It is a further object of the present invention to provide an analog to digital conversion system which provides more quantization levels on the low end of the analog signal and less quantization levels on the high end of the analog signal.

These objects are achieved in an analog to digital conversion system which receives an input analog signal from, for example, an image sensor and converts it to a piecewise-linear gamma corrected digital signal comprising:

a) first and second conversion stages wherein the first conversion stage has a plurality of first comparators and means for generating a first set of proportional reference voltages which set the break points of a piecewise-linear gamma transfer curve and are applied to the first comparators, means for applying the analog voltage to each of the first comparators which provide first comparator output signals, means responsive to such first comparator output signals to provide the most significant bits of the piecewise-linear gamma corrected digital signal;

b) means for selecting a reference voltage $V_{high2}$ depending upon which section of the piecewise-linear gamma transfer curve corresponds to the input analog signal;

c) means for subtracting an analog signal representing the digital signal's most significant bits from the input analog signal to provide an adjusted input analog signal; and

d) the second stage including means for producing a second set of proportional reference voltages and a plurality of second comparators each responsive to the adjusted analog voltage and the second set of proportional reference voltages for producing second comparator output signals; and

e) means responsive to the second comparator output signals for producing digital signals representing the least significant bits of the piecewise-linear gamma transfer digital signal, whereby the least significant bits and the most significant bits provide the piecewise-linear gamma corrected digital signal.

## Advantages

In accordance with the invention, high quality gamma corrected output digital representations of an analog input signal can be provided, which are particularly suited to electronic imaging applications.

## BRIEF DESCRIPTION OF THE DRAWINGS

FIG. 1 depicts a block diagram of an analog to digital conversion system according to the present invention;
FIG. 2 shows in more detail the $V_{high2}$ control system block of FIG. 3; and
FIG. 3 depicts a piecewise-linear gamma corrected transfer function graph produced by the system of FIG. 1.

## DETAILED DESCRIPTION OF THE INVENTION

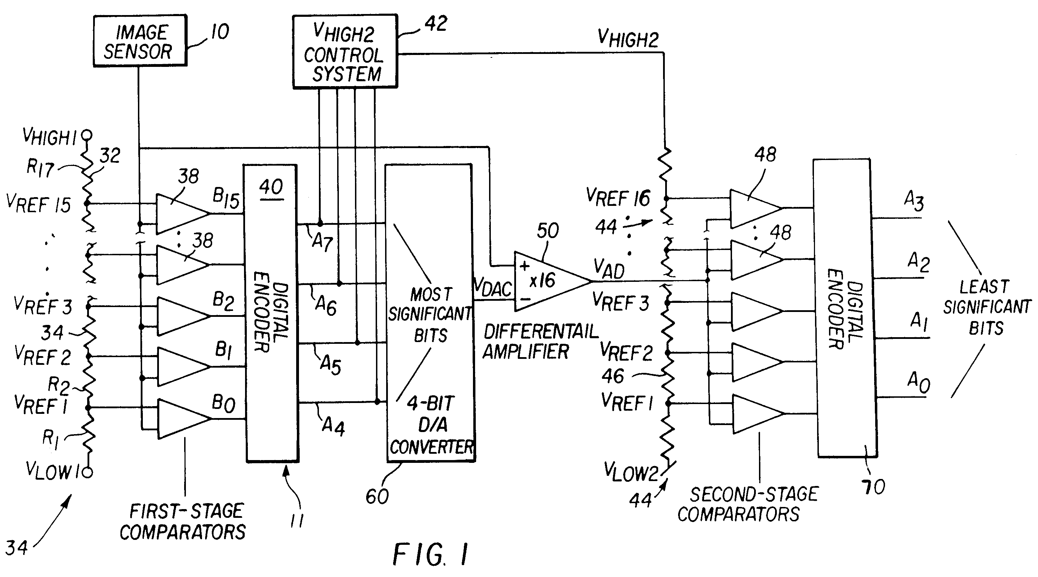

Turning now to FIG. 1, we see an analog input signal provided to an analog to digital conversion system. This analog input signal will be understood to be provided by an electronic imaging device such as an imaging sensor 10. As shown in a first conversion stage 11, there are a series of seventeen proportional resistors ($R_1$-$R_{17}$) 12 which comprise a non-linearly weighted resistor ladder 34.

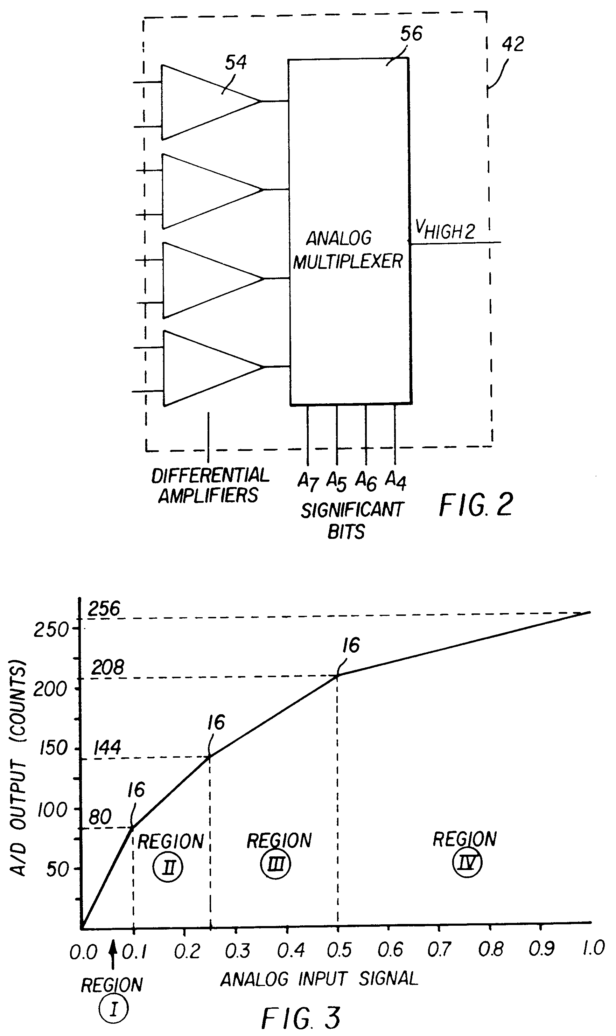

A fixed reference voltage $V_{high1}$ (1 volt) is applied to the top of the ladder 34 and fixed low reference voltage $V_{low1}$ (0 volt) is affixed to the bottom of the ladder 34. Ladder 34 sets up a series of reference voltages $V_{REF(1-16)}$ (see Table 1). The graph of FIG. 3 shows break points 16 of the piecewise-linear gamma correction transfer function which separate four separate regions. The reference voltages which are between the break points are linear.

TABLE 1

| $V_{REF(1-16)}$ Volts | $R_{1-17}$ (Ohms) |
|---|---|
| $V_{LOW} = 0.00V$ | |
| $V_{REF1} = 0.02V$ | $R_1 = 20\Omega$ |
| $V_{REF2} = 0.04V$ | $R_2 = 20\Omega$ |
| $V_{REF3} = 0.06V$ | $R_3 = 20\Omega$ |
| $V_{REF4} = 0.08V$ | $R_4 = 20\Omega$ |
| $V_{REF5} = 0.10V$ | $R_5 = 20\Omega$ |
| $V_{REF6} = 0.14V$ | $R_5 = 40\Omega$ |
| $V_{REF7} = 0.18V$ | $R_7 = 40\Omega$ |
| $V_{REF8} = 0.22V$ | $R_5 = 40\Omega$ |
| $V_{REF9} = 0.26V$ | $R_9 = 40\Omega$ |
| $V_{REF10} = 0.32V$ | $R_{10} = 60\Omega$ |
| $V_{REF11} = 0.38V$ | $R_{11} = 60\Omega$ |
| $V_{REF12} = 0.44V$ | $R_{12} = 60\Omega$ |
| $V_{REF13} = 0.50V$ | $R_{13} = 60\Omega$ |
| $V_{REF14} = 0.66V$ | $R_{14} = 160\Omega$ |
| $V_{REF15} = 0.82V$ | $R_{15} = 160\Omega$ |
| $V_{REF16} = 0.98V$ | $R_{16} = 160\Omega$ |
| $V_{HIGH} = 1.00V$ | $R_{17} = 20\Omega$ |

The first conversion stage also includes sixteen comparators 38, each being responsive to the analog input signal and one of the reference voltages $V_{REF(1-16)}$. A four bit digital encoder 40 encodes the outputs from the comparators 38 and produces an output $A_4$, $A_5$, $A_6$ and $A_7$ which corresponds to the four most significant bits of the desired piecewise-linear gamma corrected digital signal. These four bits are provided to a control system 42 and a four bit D/A converter 60 which converts those four most significant bits to an analog voltage labeled $V_{DAC}$. The control system 42, which will be described in more detail later, selects a voltage $V_{high2}$ which corresponds to one of the four sections of the gamma transfer curve wherein lies the input signal level. The $V_{high2}$ signal can be between 0-1.0 volts. This voltage $V_{high2}$ is applied to the top of a linear resistor ladder 44 formed of seventeen equally weighted resistors 46 which produces a second set of linearly (proportional) weighted output voltages to a second set of comparators 48. The resistor ladder 44 and the comparators 48 form a second conversion stage.

The resistor ladders 34 and 44 are both adapted to receive a fixed input voltage and produce proportional reference voltages. The ladder 34 includes groups of resistors. Each resistor in each group in ladder 34 has the same resistance value but such value is different from that in the other groups. In ladder 44 all the resistors have the same resistance value.

At the bottom of the ladder 44, a fixed reference voltage $V_{low2}$ (0 volt) is applied. Sixteen separate reference outputs are applied to respective inputs of the second stage having 16 comparators 48. A differential amplifier 50 receives two inputs, one the original analog signal and the other the analog signal $V_{DAC}$. Differential amplifier 50 produces an adjusted analog signal proportional to the difference between its two input signals. The adjusted analog signal is applied to each of the second stage comparators 48. A second digital encoder 70 receives the output of the comparators 48 and produces the four least significant bits $A_3, A_2, A_1, A_0$ of the piecewise-linear gamma corrected digital signal. The most significant bits $A_7, A_0, A_5, A_4$ and the least significant bits $A_3, A_2, A_1, A_0$, of course, comprises the finally converted piecewise-linear gamma corrected digital signals.

Turning now to FIG. 2 where a more detailed block diagram of the control system 42 is shown. There are provided four differential amplifiers 54, one for each linear section of the piecewise-linear gamma corrected transfer function (see FIG. 3). These differential amplifiers receive as inputs voltages from the resistor ladder 34. Each differential amplifier 54 receives two reference voltages from the resistor ladder 34 within its corresponding section. The differential amplifiers provide a signal to a multiplexer 56. The multiplexer 56 also receives as an input, signals $A_7$, $A_6, A_0, A_4$ corresponding the most significant bits of the output digital signal. Based upon these input signals $A_7, A_6, A_5, A_4$, one of the output voltages from the differential amplifiers 54 is selected as $V_{high2}$.

**Claims**

1. An analog to digital conversion system which receives an input analog signal from, for example, an image sensor and converts it to a piecewise-linear gamma corrected digital signal comprising:

   a) first and second conversion stages wherein the first conversion stage has a plurality of first comparators and means for generating a first set of proportional reference voltages which set the break points of a piecewise-linear gamma transfer curve and are applied to the first comparators, means for applying the analog voltage to each of the first comparators which provide first comparator output signals, means responsive to such first comparator output signals to provide the most significant bits of the piecewise-linear gamma corrected digital signal;

   b) means for selecting a reference voltage

$V_{high2}$ depending upon which section of the piecewise-linear gamma transfer curve corresponds to the input analog signal;

   c) means for subtracting an analog signal representing the digital signal's most significant bits from the input analog signal to provide an adjusted input analog signal;

   d) the second stage including means for producing a second set of proportional reference voltages and a plurality of second comparators each responsive to the adjusted analog voltage and the second set of proportional reference voltages for producing second comparator output signals; and

   e) means responsive to the second comparators output signals for producing digital signals representing the least significant bits of the piecewise-linear gamma transfer digital signal, whereby the least significant bits and the most significant bits provide the piecewise-linear gamma corrected digital signal.

2. The system of claim 1 wherein nonlinear reference voltages means includes a resistor ladder having group of resistors, with the resistance of each resistor in each group having the same resistance values but with the resistance values of each group being different.

3. The system of claim 2 wherein the reference voltage $V_{high2}$ selection means includes an analog multiplexer.

FIG. 1

EP 0 654 908 A1

FIG. 2

FIG. 3

6

European Patent Office

**EUROPEAN SEARCH REPORT**

Application Number

EP 94 42 0316

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN vol. 015, no. 486 (E-1143) 10 December 1991 & JP-A-03 212 025 (CANON INC) 17 September 1991 * abstract * | 1-3 | H03M1/16 |
| X | FR-A-2 199 233 (CIT ALCATEL ) 5 April 1974 * page 1, line 19-24 * * page 4, line 15-39; figures 1-5 * | 1,3 | |
| X | FR-A-2 454 229 (CENTRE NAT ETD SPATIALES) 7 November 1980 * figure 1 * | 1 | |
| | | | **TECHNICAL FIELDS SEARCHED (Int.Cl.6)** |
| | | | H03M |

The present search report has been drawn up for all claims

| Place of search | Date of completion of the search | Examiner |
|---|---|---|
| THE HAGUE | 24 February 1995 | Beindorff, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

7